# EUROPEAN PATENT APPLICATION

(11) **EP 1 475 843 A2**
(43) Date of publication of application: **10.11.2004**
(21) Application number: 04010784.9
(22) Date of filing: 06.05.2004
(51) Int. Cl.: H01L 31/075, H01L 31/20, H01L 31/0224, H01L 31/0368

(54) **Photovoltaic element and method of forming photovoltaic element**

(30) Priority: 09.05.2003 JP 2003131168
(71) Applicant: Canon Kabushiki Kaisha, Tokyo (JP)
(72) Inventor: Kondo, Takaharu, Ohta-ku Tokyo (JP); Sano, Masafumi, Ohta-ku Tokyo (JP); Takai, Yasuyoshi, Ohta-ku Tokyo (JP); Higashikawa, Makoto, Ohta-ku Tokyo (JP); Tsuzuki, Hidetoshi, Ohta-ku Tokyo (JP); Nakamura, Tetsuro, Ohta-ku Tokyo (JP)
(74) Representative: Böckelen, Rainer

(57) **Abstract**

The present invention provides a photovoltaic element including a structure with a first pin-junction having an i-type semiconductor layer made of amorphous silicon and a second pin-junction having an i-type semiconductor layer containing crystalline silicon which are arranged in series on a substrate, wherein the first pin-junction has a first intermediate layer at a p/i interface and a second intermediate layer at an n/i interface, and the second pin-junction has a third intermediate layer at a p/i interface and a fourth intermediate layer at an n/i interface, and wherein the second intermediate layer and the third intermediate layer are made of amorphous silicon and the first intermediate layer and the fourth intermediate layer contain crystalline silicon, or wherein the second intermediate layer and the third intermediate layer contain crystalline silicon and the first intermediate layer and the fourth intermediate layer are made of amorphous silicon.

## Description

### BACKGROUND OF THE INVENTION

### Field of the Invention

The present invention relates to a photovoltaic element and a method of forming the photovoltaic element.

### Related Background Art

A solar cell, which is an example of a photovoltaic element having a structure obtained by stacking semiconductor layers, has advantages over existing energy using fossil fuel in that it has an inexhaustible energy source and its power generating process is clean. However, promoting the spread of the solar cell requires a further reduction of the unit price per an amount of power generated. For this reason, there are important technological challenges such as establishing a production technology for realizing a cost reduction and establishing a technology for improving the efficiency of photoelectric conversion.

Here, a high-frequency plasma CVD method has advantages of facilitating the realization of large areas and low-temperature formation and improving the process throughput, and is one of the most promising means as a method of forming a photovoltaic element. Furthermore, as means for improving characteristics of the photovoltaic element, a structure called a "stacked type," which provided with a plurality of photovoltaic elements, is known as one of the most promising means. In the stacked type photovoltaic element, by combining a photovoltaic element having a photoelectric conversion layer made of a wide band gap material on the incident light side with another photovoltaic element having a photoelectric conversion layer made of a narrow band gap material, it is possible to increase the spectral sensitivity of the photovoltaic element as a whole. In the case of a stacked type photovoltaic element having a double-layer structure, there are various combinations of photoelectric conversion layers, such as a structure consisting, in order from the incident light side, of a-Si/a-SiGe, a-SiC/a-Si, a-Si/µC-Si, a-Si/a-Si, µC-Si/µC-Si (here, "a-" means amorphous and "µC-" means microcrystalline.). These can be formed by adopting a structure combining the respective materials also in the case of a stacked type photovoltaic element having a structure with three or more layers. When the above-described stacked type photovoltaic element is designed, various methods are used according to the cell structure of a stacked type photovoltaic element to be created and characteristics of each photovoltaic element, etc., for example, a method of substantially equalizing the number of carriers generated by individual photovoltaic elements or a method of limiting the overall short-circuit current value using a specific photovoltaic element.

As a photovoltaic element made up of a plurality of the above-described photovoltaic elements connected in series in the thickness direction, Japanese Patent Application Laid-Open No. H11-243219 discloses a stacked photovoltaic element having at least a stacked structure of a pin-junction constituting element including a microcrystalline semiconductor in an i-type layer and a pin-junction constituting element including an amorphous semiconductor in an i-type layer on a support member, characterized in that the current value is limited by the pin-junction constituting element including the microcrystalline semiconductor in the i-type layer. Furthermore, Japanese Patent Application Laid-Open No. H11-243218 discloses a stacked photovoltaic element having a stacked structure of a plurality of pin-junction constituting element including a p-type layer, i-type layer and n-type layer consisting of silicon-based non-single-crystalline semiconductor, characterized in that amorphous silicon is used in an i-type layer of a first pin-junction,
microcrystalline silicon is used in an i-type layer of a second pin-junction and microcrystalline silicon is used in an i-type layer of a third pin-junction, from the incident light side.

According to the above-described stacked cell technology, the characteristics of the photovoltaic element have been drastically improved.

On the other hand, achieving a further cost reduction requires a technology for making high-speed film formation compatible with high-level characteristics.

For example, as one of the methods for achieving the above-described object, there is a study on a method of realizing high-frequency plasma CVD by providing a substrate and a high-frequency introduction section facing the substrate and applying a high frequency to the high-frequency introduction section. This plasma CVD method may have problems of damages occurring on the semiconductor interface or mismatch occurring between upper and lower layers, thereby reducing the characteristics, when the distance between the substrate and high-frequency introduction section is decreased or when high-frequency power applied is increased. The photovoltaic element having a pin-junction especially requires speed enhancement of the i-type semiconductor layer having a thickness with a large percentage of the total layer thickness, but under the layer formation condition in pursuit of high-speed film formation, there is a problem that not only the characteristics of the layer itself but also the interface condition with the neighboring layer deteriorates. Furthermore, when crystalline silicon of different conductivity types and/or shapes is formed successively, the grain boundary condition becomes more complicated, which increases the interface level and mechanical distortion, resulting in deterioration of the characteristics of the photovoltaic element.

### SUMMARY OF THE INVENTION

In view of the above-described problems, it is an object of the present invention to form a photovoltaic element with improved characteristics at a lower cost and a large formation rate than the conventional photovoltaic element.

The present invention provides a photovoltaic element formed on a substrate, comprising a first semiconductor layer and a second semiconductor layer containing crystalline silicon of at least different conductivity types and/or shapes from each other, wherein an amorphous intermediate layer is arranged between the first semiconductor layer and the second semiconductor layer.

The present invention provides a photovoltaic element comprising a structure with a first pin-junction having a substantially intrinsic semiconductor layer (hereinafter, referred to as "i-type semiconductor layer") made of amorphous silicon and a second pin-junction having an i-type semiconductor layer containing crystalline silicon which are arranged in series on a substrate, wherein the first pin-junction has a first intermediate layer at a p/i interface and a second intermediate layer at an n/i interface, and the second pin-junction has a third intermediate layer at a p/i interface and a fourth intermediate layer at an n/i interface, wherein the second intermediate layer and the third intermediate layer are made of amorphous silicon and the first intermediate layer and the fourth intermediate layer contain crystalline silicon, or the second intermediate layer and the third intermediate layer contain crystalline silicon and the first intermediate layer and the fourth intermediate layer are made of amorphous silicon.

The present invention provides a photovoltaic element comprising a structure with a first pin-junction having an i-type semiconductor layer made of amorphous silicon and a second pin-junction having an i-type semiconductor layer made of crystalline silicon which are arranged in series on a substrate, wherein the first pin-junction has a first intermediate layer containing crystalline silicon at an interface on an incident light side of the i-type semiconductor layer and a second intermediate layer containing amorphous silicon at an interface on a back side of the i-type semiconductor layer, and the second pin-junction has a third intermediate layer containing amorphous silicon at an interface on an incident light side of the i-type semiconductor layer and a fourth intermediate layer containing crystalline silicon at an interface on a back side of the i-type semiconductor layer.

The present invention provides a photovoltaic element comprising a structure with a first pin-junction having an i-type semiconductor layer made of amorphous silicon and a second pin-junction having an i-type semiconductor layer made of crystalline silicon which are arranged in series on a substrate, wherein an interface on a first side of the i-type semiconductor layer of the first pin-junction is in contact with a layer containing microcrystalline silicon, an interface on a second side of the i-type semiconductor layer of the first pin-junction is in contact with a layer made of amorphous silicon, an interface on a first side of the i-type semiconductor layer of the second pin-junction is in contact with a layer containing amorphous silicon, and an interface on a second side of the i-type semiconductor layer of the second pin-junction is in contact with a layer containing microcrystalline silicon.

The present invention provides a method of forming a photovoltaic element, which comprising:
applying a high frequency to a high-frequency introduction section to carry out high-frequency plasma CVD, the high-frequency introduction section facing a substrate, and the substrate and high frequency introduction section being arranged in a reaction container that can be decompressed; and
forming a photovoltaic element comprising a first pin-junction having an i-type semiconductor layer made of amorphous silicon, a second pin-junction having an i-type semiconductor layer made of crystalline silicon which are arranged in series on the substrate, and an intermediate layer at a p/i interface or n/i interface of the pin-junctions,
wherein a high frequency for forming the i-type semiconductor layer is greater than a frequency for forming the intermediate layer.

In the above-described structure, the order of stacking the first pin-junction and second pin-junction can be determined arbitrarily, but the first pin-junction is preferably positioned closer to the incident light side than the second pin-junction.

In the above-described structure, the i-type semiconductor layer functions as a main photoactive layer.

Any one of the first semiconductor layer and second semiconductor layer is preferably a p-type or n-type semiconductor layer, and the other semiconductor layer is preferably a substantially intrinsic semiconductor layer. The formation rate of the intermediate layer is preferably smaller than the formation rate of the i-type semiconductor layer and the film thickness of the intermediate layer is preferably equal to or less than 1/5 of the film thickness of the i-type semiconductor layer. The intermediate layer is preferably made of an intrinsic semiconductor layer. The intermediate layer is preferably made of a semiconductor layer of the same conductivity type as the conductivity type of adjacent n- or p-type semiconductor layer. The p-type semiconductor layer of the first pin-junction is preferably made of crystalline silicon, and the n-type semiconductor layer thereof is preferably made of amorphous silicon. The p-type semiconductor layer of the second pin-junction is preferably made of crystalline silicon, and the n-type semiconductor layer thereof is preferably made of amorphous silicon. The i-type semiconductor layer of the second pin-junction is preferably made of crystalline silicon which extends in the film deposition direction, and the p-type semiconductor layer thereof is preferably made of crystalline silicon in a quasi-spherical shape. A plurality of first pin-junctions and/or second pin-junctions are preferably arranged in series. As such a mode, there is a structure including a first pin-junction and a second pin-junction in order from the incident light side as an example of two pin-junctions arranged in series, or a structure including a first pin-junction, a second pin-junction and another second pin-junction in order from the incident light side as an example of three pin-junctions arranged in series. The high frequency when the i-type semiconductor layer is formed is preferably greater than the frequency when the n-type semiconductor layer and p-type semiconductor layer are formed. The formation pressure of the i-type semiconductor layer included in the second pin-junction is preferably greater than the formation pressure of the i-type semiconductor layer included in the first pin-junction. The formation pressure of the i-type semiconductor layer included in the second pin-junction is preferably equal to or greater than three times the formation pressure of the i-type semiconductor layer included in the first pin-junction. When the first pin-junction is formed, the distance between the substrate and the high-frequency introduction section for forming the i-type semiconductor layer is preferably smaller than the distance between the substrate and the high-frequency introduction section for forming an n-type semiconductor layer, intermediate layer and p-type semiconductor layer. When the second pin-junction is formed, the distance between the substrate and the high-frequency introduction section for forming the i-type semiconductor layer is preferably smaller than the distance between substrate and the high-frequency introduction section for forming the n-type semiconductor layer, intermediate layer and p-type semiconductor layer. The distance between the substrate and the high-frequency introduction section when the i-type semiconductor layer of the first pin-junction is formed is preferably greater than the distance between the substrate and the high-frequency introduction section when the i-type semiconductor layer of the second pin-junction is formed.

When a semiconductor layer is formed at a high speed, the present invention can suppress damages on the semiconductor interface or mismatch between upper and lower layers and suppress increases of the interface level density or mechanical distortion which occur when crystalline silicon of different conductivity types and/or shapes is formed successively, and can thereby obtain a photovoltaic element with high-level characteristics.

### BRIEF DESCRIPTION OF THE DRAWINGS

FIG. 1 is a schematic cross-sectional view showing an example of a photovoltaic element including a semiconductor layer according to the present invention;
FIG. 2 is a schematic cross-sectional view showing an example of a deposited-film formation apparatus which produces the semiconductor layer and the photovoltaic element according to the present invention; and
FIG. 3 is a schematic cross-sectional view showing an example of the photovoltaic element including the semiconductor layer according to the present invention.

### DESCRIPTION OF THE PREFERRED EMBODIMENTS

As a result of making every effort to solve the above-described problems, the present inventors have discovered that by using a photovoltaic element and a method of forming the photovoltaic element according to the present invention, even when a semiconductor layer is formed at a high speed, it is possible to suppress damages on the semiconductor interface or mismatch between upper and lower layers and suppress increases of the interface level density or mechanical distortion which occur when crystalline silicon of different conductivity types and/or shapes is formed successively, and thereby obtain a photovoltaic element with high-level characteristics.

Adopting the above-described structure will result in the following operations.

In the case of semiconductor layers containing crystalline silicon of different conductivity types and/or shapes contacting with each other, many carriers optically generated in an active layer are annihilated due to recoupling near the junction interface, thereby resulting in a problem that the carriers cannot be extracted to the outside. In the case of a structure with semiconductor layers containing crystalline silicon with different shapes contacting with each other, for example, when one layer has a shape extending in a specific direction such as a columnar or conical shape and the other has a less directional shape such as a quasi-spherical shape, mismatching areas are induced in the vicinity of gain boundaries. Therefore, it seems to be possible to reduce mismatching by an effect of compensating the mismatching of grain boundaries by inserting an amorphous intermediate layer having structural flexibility between both layers and thereby suppress the annihilation of carriers. In the case of a structure having successive microcrystalline silicon with different grating constants caused by formation conditions and shapes, etc., it seems to be possible to produce the effect of lowering the interface level density by inserting an amorphous intermediate layer. Furthermore, using an amorphous phase having a greater band gap than crystalline silicon for the intermediate layer makes it possible to prevent carriers from being inversely injected into conductivity type layers. Here, the "film (or layer) containing crystalline silicon" in the present invention is a film containing silicon crystal grains made of single crystals, and typical examples include a film containing crystals having a shape extending in a specific direction such as a columnar or conical shape having a grain diameter of 10 to 5,000 nm and a film containing spherical (micro)crystals having a grain diameter of 1 to 1,000 nm, or a film containing these crystals mixed. The "film (or layer) containing crystalline silicon" in the present invention can be identified from the fact that diffractive peaks can be confirmed using X-rays or that silicon is detected using an SIMS, etc. On the other hand, the "film (or layer) containing amorphous silicon" can be identified from the fact that no structure having long-distance order is included, that no clear diffractive peaks can be confirmed using X-rays or that silicon is detected using an SIMS, etc. The term "film (or layer) containing crystalline silicon" and the term "film (or layer) containing amorphous silicon" do not exclude a silicon alloy film such as a film made of silicon germanium or film made of silicon carbide.

As a structure for improving characteristics of a photovoltaic element, a so-called stacked type photovoltaic element is known in which two or more pin-junctions or pn-junctions connect in series in such a way that semiconductor layers having different band gaps are stacked and can collect a wider optical energy spectrum. The spectral sensitivity of the entire photovoltaic element as a photoelectric conversion element can be improved by using a wide band gap material on the incident light side and combining it with a narrow band gap material. An example of this is a structure using an amorphous layer for an i-type semiconductor layer of a pin-junction as a light absorption layer on the incident light side and using a layer containing microcrystals for an i-type semiconductor layer on the back side thereof. Furthermore, it is also possible to combine amorphous alloy materials made of silicon plus atoms for changing band gaps, for example, to combine silicon with a-SiN, a-SiC or a-SiO as a wide band gap material rather than amorphous a-Si with a-SiGe or the like as a narrow band gap material rather than a-Si. The photovoltaic element can also have a structure combining three or more pin-junctions. Furthermore, in the case of a pin-junction, a semiconductor layer having an i-type semiconductor layer containing crystalline silicon is preferable because it can suppress optical deterioration of a photovoltaic element. In view of all that has been described above, examples of preferable stacked type structures include, as a combination of i-type semiconductor layers of various pin-junctions, a-Si/µC-Si, a-SiC/µC-Si, a-Si/µC-Si/µC-Si, a-Si/a-Si/µC-Si, a-Si/µC-Si/a-SiGe, a-Si/a-SiGe/µC-Si, etc., in order from the incident light side. These can also have structures combining four or more pin-junctions.

A photovoltaic element including a structure in which two or more pin-junctions are connected in series can realize higher performance as the photovoltaic element by inserting intermediate layers formed using a specific crystal system or a formation method between an i-type semiconductor layer and n-type semiconductor layer or p-type semiconductor layer. Here, preferable intermediate layers in a photovoltaic element including a structure in which a first pin-junction having an i-type semiconductor layer made of amorphous silicon and a second pin-junction having an i-type semiconductor layer made of crystalline silicon are arranged in series include a first intermediate layer containing crystalline silicon at the p/i interface of the first pin-junction, a second intermediate layer made of amorphous silicon at the n/i interface thereof, a third intermediate layer made of amorphous silicon at the p/i interface of the second pin-junction and a fourth intermediate layer containing crystalline silicon at the n/i interface thereof.

This is because it is preferable to absorb more light of a short wavelength region through the i-type semiconductor layer in the case of the first pin-junction, and therefore it is preferable to suppress light absorption in the p-type semiconductor layer to a minimum in the structure in which light is introduced from the p-type semiconductor layer side. For this reason, the p-type semiconductor layer of the first pin-junction preferably has a structure of microcrystals for low absorption. In this case, when the first intermediate layer is constructed so as to contain crystalline silicon, it is possible to form the p-type semiconductor layer into a microcrystal structure having a smaller thickness and desired conductivity type characteristics compared to a case with no first intermediate layer or a case where the first intermediate layer contains no crystalline silicon, and therefore it is possible to further suppress absorption of the short wavelength component through the p-type semiconductor layer. Thus, adopting the above-described structure for the first intermediate layer which is the incident light side of the stacked cell allows more light in the short wavelength region to be absorbed by the i-type semiconductor layer, and is therefore preferable. Furthermore, under the condition that the formation rate of the second intermediate layer is made smaller than that of the i-type semiconductor layer, by using an amorphous silicon layer having plasma damage at the time of formation smaller than that of the i-type semiconductor layer, the effect of suppressing damage to an underlying layer and annihilation of carriers in the interface is preferably enhanced.

Furthermore, for the second pin-junction, it is preferable to design an intermediate layer from the standpoint that light in a longer wavelength region which has not been absorbed through the first pin-junction is absorbed more efficiently. When a semiconductor layer containing crystalline silicon is used for the i-type semiconductor layer in the second pin-junction, it preferably has a microcrystal structure that crystal grains extend in a film-growing direction because the crystal grain boundary density with respect to a carrier-traveling direction is reduced. This structure is preferable because it is possible to cancel the mismatching region due to the difference in shape between microcrystals of the p-type semiconductor layer and microcrystals of the i-type semiconductor layer by inserting the third intermediate layer made of an amorphous material, suppress the annihilation of carriers and extract more photocarriers. Furthermore, a structure containing crystalline silicon for the fourth intermediate layer is used for the fourth intermediate layer to function as a nucleus formation layer for the i-type semiconductor layer of the second pin-junction, and the i-type semiconductor layer is preferably formed with a high degree of crystallinity from the formation initial region thereof.

Here, to realize the respective functions of the intermediate layers, it is preferable to form the intermediate layers at a formation rate which is smaller than the formation rates of the respective i-type semiconductor layers, and the intermediate layers only need to have a film thickness necessary to realize the respective functions to a desired degree. When the intermediate layers are excessively thick, it takes a considerable time to form the photovoltaic element and it is impossible to ignore contribution to light absorption in the intermediate layer, but due to the difference between the function required as the intermediate layer and the function required as the i-type semiconductor layer, there is a difference in the amount of hydrogen content and conductivity when optimized, and therefore when the intermediate layers are excessively thickened, the conversion efficiency of the photovoltaic element reduces contrarily. Based on the above-described considerations, the film thickness of the intermediate layer is preferably within a range of 1/1000 or more and 1/5 or less of the film thickness of the adjacent i-type semiconductor layer. Furthermore, the range of the film thickness is preferably 1 nm to 100 nm, more preferably 2 nm to 80 nm or most preferably 3 nm to 50 nm. The intermediate layer can be a substantially intrinsic semiconductor layer or can be a semiconductor layer of the same conductivity type as the conductivity type of the adjacent n- or p-type semiconductor layer by introducing dopant. Furthermore, it is also possible to provide the concentration of dopant atoms with a distribution to slow a variation of the conductivity type.

For the photovoltaic element including pin-junctions, the film thickness of the i-type semiconductor layer has the largest percentage of the total film thickness of the pin layer. For this reason, when a pin-junction is formed using the high-frequency plasma CVD method, the i-type semiconductor layer needs to be formed at a higher rate. Thus, by forming the i-type semiconductor layer using a higher frequency, the quantity of electrons with a high energy in the plasma increases and high-speed film formation can be preferably carried out. Furthermore, when the i-type semiconductor layer is formed, by making the distance between the substrate and high-frequency introduction section smaller than that when the intermediate layer, n-type semiconductor layer and p-type semiconductor layer are formed, the plasma density increases and thereby high-speed film formation can be carried out. Furthermore, in addition to the small amount of light incident upon the semiconductor layer, since the crystalline silicon contained in the i-type semiconductor layer of the second pin-junction is an indirect transition material, a greater film thickness than amorphous silicon is required to carry out necessary light absorption. For this reason, as the condition for forming the i-type semiconductor layer of the second pin-junction, it is preferable to form the i-type semiconductor layer of the second pin-junction using greater high-frequency power under a higher pressure than the i-type semiconductor layer of the first pin-junction. Furthermore, the distance between the substrate and high-frequency introduction section when the i-type semiconductor layer of the second pin-junction is formed is preferably smaller than that when the i-type semiconductor layer of the first pin-junction is formed. When a pin-junction is formed using a roll-to-roll method formation pressures of deposited films which are successively formed become substantially equal, and therefore when desired formation pressures differ between the first pin-junction and second pin-junction, the first pin-junction is formed at a predetermined pressure first and then the second pin-junction is preferably formed on the first pin-junction by changing the pressure setting to a different pressure.

Then, an example of components constituting the photovoltaic element of the present invention will be explained.

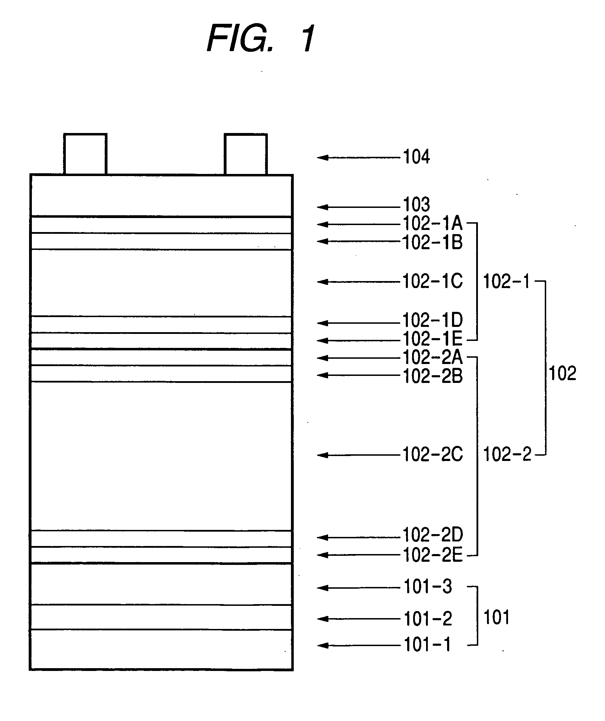

FIG. 1 is a schematic cross-sectional view showing an example of the photovoltaic element of the present invention. In the figure, reference numeral 101 denotes a substrate, 102 denotes a semiconductor layer, 103 denotes a second transparent conductive layer and 104 denotes a collecting electrode. Furthermore, reference numeral 101-1 denotes a base, 101-2 denotes a reflection layer and 101-3 denotes a first transparent conductive layer, which are the components of the substrate 101.

### (Base)

As the base 101-1, a plate- or sheet-shaped member made of metal, resin, glass, ceramics, semiconductor bulk, etc., is preferably used. The surface thereof may have fine projections and depressions. Or a transparent base may be used so that light can enter from the base side. Furthermore, adopting a long base allows successive film formation using a roll-to-roll method. Especially a flexible material such as stainless steel or polyimide is preferable as the material for the base 101-1.

### (Reflection layer)

The reflection layer 101-2 has the role as an electrode and the role of reflecting the arrived light so as to be reused for the semiconductor layer 102. As the material thereof, Al, Cu, Ag, Au, CuMg and AlSi or an alloy thereof can be preferably used. Furthermore, using a stacked structure with a transition metal such as Ni, Cr and Ti for the reflection layer 101-2 can be expected to have the effect of improving the adhesion between the base 101-1 and reflection layer 101-2. The reflection layer 101-2 can be preferably formed using vapor deposition, sputtering, electrodeposition or printing, etc. The reflection layer 101-2 preferably has projections and depressions on the surface. This makes it possible to extend the optical path length of reflected light in the semiconductor layer 102 and increase a short-circuit current. When the base 101-1 has conductivity, the metal layer 101-2 need not be formed.

Furthermore, when light is introduced from the base side, it is preferable to provide the reflection layer not on the base but on the semiconductor layer (or on the semiconductor layer provided with a transparent conductive layer).

### (First transparent conductive layer)

The first transparent conductive layer 101-3 has the role of increasing irregular reflection of the incident light and reflected light to extend the optical path length in the semiconductor layer 102. It also has the role of preventing elements of the reflection layer 101-2 from diffusing or migrating into the semiconductor layer 102 to shunt the photovoltaic element. Furthermore, when it has an appropriate resistance, it also has the role of preventing short-circuit due to defects such as pinholes in the semiconductor layer 102. Furthermore, the first transparent conductive layer 101-3 preferably has projections and depressions on the surface. The first transparent conductive layer 101-3 is preferably made of conductive oxide such as ZnO, ITO (indium tin oxide) and preferably formed using methods such as vapor deposition, sputtering, CVD, electrodeposition or by combining these methods. It is also possible to add a substance for changing conductivity to these conductive oxides.

The condition for forming a zinc oxide film as the first transparent conductive layer by sputtering is greatly affected by a method, the kind, flow rate and inner pressure of a gas, a power applied, a film formation rate, a substrate temperature, etc. For example, when a zinc oxide film is formed using a zinc oxide target by a DC magnetron sputtering method, the kinds of the gases such as Ar, Ne, Kr, Xe, Hg, O₂, etc. can be used. The flow rate differs depending on an apparatus size and an exhaust speed and when, for example, the volume of the film formation space is 20 liters, the flow rate is preferably 1 cm³/min (normal) to 100 cm³/min (normal). Furthermore, the inner pressure during film formation is preferably 10 mPa to 10 Pa. Furthermore, the power applied depends on the size of the target, but it is preferably 10 W to 10 KW. Furthermore, the preferable range of the substrate temperature depends on the film formation rate, but it is preferably 70°C to 450°C.

Furthermore, as the condition for forming a zinc oxide film as the first transparent conductive layer using an electrodeposition method, it is preferable to use an aqueous solution containing nitrate ions, zinc ions in an anticorrosive container. The concentration of nitrate ions, zinc ions is preferably within a range of 0.002 mol/l to 2.0 mol/l, more preferably within a range of 0.01 mol/l to 1.0 mol/l and further preferably within a range of 0.1 mol/l to 0.5 mol/l. A supply source of nitrate ions, zinc ions is not particularly limited and can be zinc nitrate which is a supply source of both ions, or a mixture of water-soluble nitrate such as ammonium nitrate which is a supply source of nitrate ions and the salt of zinc such as zinc sulfate which is a supply source of zinc ions.

Furthermore, it is also preferable to add carbohydrate such as saccharose and dextrin to the aqueous solution to suppress abnormal growth or improve adhesion. The amount of carbohydrate in the aqueous solution depends on the kind of carbohydrate, but in the case of saccharose, it is generally preferably 1 g/l to 500 g/l, more preferably 3 g/l to 100 g/l and in the case of dextrin, it is preferably 0.01 g/l to 10 g/l, or more preferably 0.025 g/l to 1 g/l. Furthermore, detailed effects and its mechanism are unknown, but for the purpose of controlling the size of the projected and depressed shapes of a product to be formed or controlling the angle of inclination of the product, it is preferable to introduce into the aqueous solution, multivalent carboxylic acid having a carboxyl group bonded to a plurality of carbons thereof having an sp² composite orbit, or its ester. Examples of the multivalent carboxylic acid having a carboxyl group bonded to a plurality of carbons thereof having an sp² composite orbit or its ester include those having a -C=C- group with carboxyl group or ester group bonded to these carbons or those with carboxyl group bonded to a plurality of carbons of an aromatic ring (benzene ring or complex aromatic ring, etc.). More specifically, phthalic acid, isophthalic acid, maleic acid, naphthalic acid or ester of these acids can be used. However, excessive multivalent carboxylic acid has a function of reducing the projected and depressed shapes of the zinc oxide film, which is therefore not preferable. As explained above, the concentration of these multivalent carboxylic acids is preferably 0.5 µmol/l to 500 µmol/l or more preferably 10 µ mol/l to 300 µmol/l. When a zinc oxide film is deposited using an electrodeposition method, it is preferable to use the base 101-1 on which a zinc oxide film is to be deposited in the aqueous solution as a cathode and use zinc, platinum or carbon, etc., as an anode. The range of the current flowing between the anode and cathode is preferably 0.1 mA/cm² to 100 mA/cm², more preferably 1 mA/cm² to 30 mA/cm², and most preferably 4 mA/cm² to 20 mA/cm².

### (Substrate)

Using the above-described method, the reflection layer 101-2 and first transparent conductive layer 101-3 are stacked on the base 101-1 as required to form the substrate 101. Furthermore, to facilitate integration of the element, an insulating layer may also be provided in the substrate 101 as an intermediate layer.

### (Semiconductor layer)

As the principal material when a silicon-based thin film is used for the semiconductor layer 102, an amorphous phase, crystalline phase or a mixture of these phases is used. Instead of Si, it is also possible to use an alloy of Si and atoms changing the band gap such as C or Ge. The semiconductor layer 102 contains hydrogen and/or halogen atoms at the same time. The preferable content is 0.1 to 40 atomic %. Furthermore, the semiconductor layer 102 may also contain oxygen and hydrogen, etc. Elements of Group III are contained in the semiconductor layer 102 to form a p-type semiconductor layer, while elements of Group V are contained to make the semiconductor layer 102 to form an n-type semiconductor layer. As the electric characteristic of the p-type layer and n-type layer, activation energy of 0.2 eV or less is preferable and 0.1 eV or less is most preferable. Furthermore, as specific resistance, 100 Ωcm or less is preferable and 1 Ωcm or less is most preferable.

In the case of a photovoltaic element having a plurality of the pin-junctions according to the present invention, the band gap is preferably wider for the i-type semiconductor layer of the pin-junction closer to the incident light side and narrower for the farther pin-junction. Furthermore, the minimum value of the band gap inside the i-type semiconductor layer preferably exists in a portion close to the p-type semiconductor layer rather than at the center of the i-type semiconductor layer in the film thickness direction. The doped layer (p-type semiconductor layer or n-type semiconductor layer) on the incident light side is suitable for a crystalline semiconductor with less light absorption or a semiconductor with a wide band gap.

Examples of combinations of i-type semiconductor layers of each pin-junction include, in order from the incident light side, a-Si/µC-Si, a-SiC/µC-Si, a-Si/µC-Si/µC-Si, a-Si/a-Si/µC-Si, a-Si/µC-Si/a-SiGe, a-Si/a-SiGe/µC-Si, etc. These can also have a structure combining four or more pin-junctions. For the i-type semiconductor layer, the absorption coefficient (α) of light (630 nm) is preferably 5,000 cm⁻¹ or above, photoconductivity (σp) of pseudo-sunlight irradiation using a solar simulator (AM 1.5, 100 mW/cm²) is preferably 10×10⁻⁵ S/cm or more, dark conductivity (σd) is preferably 10×10⁻⁶ S/cm or less and Urbach energy by a constant photocurrent method (CPM) is preferably 55 meV or less. As i-type semiconductor layers, those slightly displaying p-type or n-type properties can also be used. Furthermore, the structure of the photovoltaic element of the present invention in which the first pin-junction having an i-type semiconductor layer made of amorphous silicon and the second pin-junction having an i-type semiconductor layer made of crystalline silicon are arranged in series on the substrate, including a first intermediate layer containing crystalline silicon at the p/i interface of the first pin-junction or the interface on the incident light side of the i-type layer, a second intermediate layer made of amorphous silicon at the n/i interface or interface on the back side of the i-type layer, a third intermediate layer made of amorphous silicon at the p/i interface of the second pin-junction or the interface on the incident light side of the i-type layer, and a fourth intermediate layer containing crystalline silicon on the n/i interface or interface on the back side of the i-type layer is a preferable structure for improving the characteristics of the photovoltaic element.

To function as a principal photoactive layer, the i-type semiconductor layer must have a certain thickness or more. On the other hand, it should not be too thick from the standpoint of costs, etc. Examples of the method of designing a photovoltaic element with a plurality of pin-junctions arranged in series include a method of making the number of carriers generated in individual pin-junctions substantially equal by adjusting the film thickness of the respective i-type semiconductor layers according to the cell structure of the stacked type photovoltaic element to be formed and characteristics of each photovoltaic element, or a method of limiting the overall short-circuit current value in a specific pin-junction. A preferable thickness of the i-type semiconductor layer is designed according to the number of pin-junctions connected in series or light absorption coefficient of the i-type semiconductor layer, but more specifically, it is preferably 150 nm to 5 µm and more preferably 200 nm to 3 µm. Furthermore, in the case of a photovoltaic element having two to three pin-junctions, the preferable range of the thickness of the i-type semiconductor layer other than the farthest i-type semiconductor layer viewed from the incident light side is further narrowed from the standpoint of sharing roles among the pin-junctions by changing the maximum absorption wavelength. More specifically, the thickness of the i-type semiconductor layer other than the farthest i-type semiconductor layer viewed from the incident light side is preferably 150 nm to 3 µm, and more preferably 200 nm to 2 µm.

### (Method of forming semiconductor layer)

A high-frequency plasma CVD method is preferably used to form the above-described semiconductor layer 102. A preferable example of a procedure for forming the semiconductor layer 102 using the high-frequency plasma CVD method will be explained below.
(1) The internal pressure of a deposition chamber (vacuum chamber) which can be set to a decompressed state is reduced to a predetermined deposition pressure.
(2) Material gases such as a source gas and a diluent gas are introduced into the deposition chamber, while exhausting the deposition chamber using a vacuum pump and set the internal pressure of the deposition chamber to a predetermined deposition pressure.
(3) The substrate 101 is heated using a heater to set it to a predetermined temperature.
(4) A high frequency oscillated by a high-frequency power supply is introduced into the deposition chamber. As one method of introducing the high frequency into the deposition chamber, the high frequency is introduced using a waveguide, passed through a dielectric window such as alumina ceramics and introduced into the deposition chamber or the high frequency is guided through a coaxial cable and introduced into the deposition chamber through a metal electrode.
(5) Plasma is generated in the deposition chamber to decompose the source gas and form a deposited film on the substrate 101 placed in the deposition chamber. This procedure is repeated a plurality of times as required to form the semiconductor layer 102.

As a preferable condition for forming the semiconductor layer 102, the substrate temperature in the deposition chamber is 100 to 450°C, the pressure is 50 mPa to 2,000 Pa and the high-frequency power is 0.001 to 5 W/cm³.

As a source gas preferably used to form the semiconductor layer 102, a gasifiable compound which contains silicon atom such as SiH₄, Si₂H₆, SiF₄, etc., can be used. When an alloy-based layer is formed, it is preferable to further add a gasifiable compound which contains Ge or C such as GeH₄ and CH₄ to the source gas. The source gas is preferably diluted with a diluent gas and introduced into the deposition chamber. As the diluent gas, H₂ or He, etc., can be used. Furthermore, it is also possible to add a gasifiable compound containing nitrogen or oxygen, etc., as a source gas or diluent gas. As the dopant gas for forming the semiconductor layer 102 into a p-type layer, B₂H₆ or BF₃, etc. can be used. Furthermore, as the dopant gas for forming the semiconductor layer 102 into an n-type layer, PH₃ or PF₃, etc. can be used. When a thin film of crystalline phase or a layer with less light absorption such as SiC or with a wide band gap is deposited, it is preferable to increase the proportion of the diluent gas with respect to the source gas and introduce a high frequency with relatively high power. As the method of introducing the source gas into the vacuum container to form a semiconductor layer with a large area, a method of providing a plurality of holes in the high-frequency introduction section and introducing the source gas through these holes into the plasma space like a shower or a method of arranging gas inlet tubes with a plurality of holes in the plasma space, etc., can form uniform plasma and is therefore preferable.

### (Second transparent conductive layer)

The second transparent conductive layer 103 is an electrode on the incident light side and if its film thickness is set appropriately, the second transparent conductive layer 103 can also serve as an anti-reflection film. The second transparent conductive layer 103 is required to have a high transmittance in the wavelength region that can be absorbed by the semiconductor layer 102 and have a low resistivity. The transmittance at 550 nm is preferably 80% or above or more preferably 85% or above. As the material for the transparent conductive layer 103, ITO, ZnO or In₂O₃, etc., can be preferably used. As the formation method, methods such as vapor deposition, CVD, spray, spin-on, immersion, etc., can be preferably used. It is also possible to add a substance for changing conductivity to these materials.

### (Collecting electrode)

The collecting electrode 104 is provided on the second transparent conductive layer 103 to improve the collecting efficiency. As the formation method, a method of forming a metal having an electrode pattern through sputtering using a mask, a method of printing a conductive paste or solder paste or a method of fixing a metal wire with a conductive paste, etc., can be used preferably.

A protective layer may be formed on both sides of the photovoltaic element as required. It is also possible to use a reinforcement member such as steel sheet for the back surface (opposite to the incident light side) of the photovoltaic element at the same time.

### <Examples>

In the following examples, the present invention will be explained more specifically referring to a solar cell as the photovoltaic element, but these examples will by no means limit the content of the present invention.

### <Example 1>

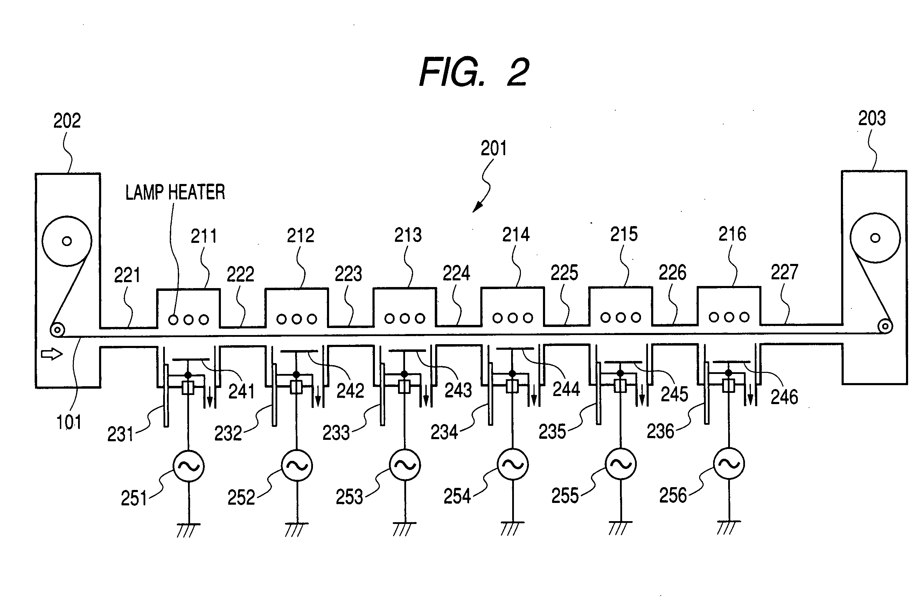

Using the deposited-film forming apparatus 201 shown in FIG. 2, the photovoltaic element shown in FIG. 1 was formed using the following procedure. FIG. 1 is a schematic cross-sectional view showing an example of the photovoltaic element of the present invention. The semiconductor layer of this photovoltaic element is constructed of a first pin-junction 102-1 and a second pin-junction 102-2 arranged in series. The first pin-junction is composed of a microcrystalline p-type semiconductor layer 102-1A, a microcrystalline intermediate layer 102-1B, an amorphous i-type semiconductor layer 102-1C, an amorphous intermediate layer 102-1D and an amorphous n-type semiconductor layer 102-1E, while the second pin-junction is composed of a microcrystalline p-type semiconductor layer 102-2A, an amorphous intermediate layer 102-2B, a microcrystalline i-type semiconductor layer 102-2C, a microcrystalline intermediate layer 102-2D and an amorphous n-type semiconductor layer 102-2E.

FIG. 2 is a schematic cross-sectional view showing an example of a deposited-film forming apparatus for forming a semiconductor layer. The deposited-film forming apparatus 201 shown in FIG. 2 is constructed of a substrate feeding container 202, semiconductor formation vacuum containers 211 to 216 and a substrate winding container 203, all connected through gas gates 221 to 227. A belt-shaped conductive substrate 101 is set in this deposited-film forming apparatus 201 so as to penetrate the respective containers and gas gates. The belt-shaped conductive substrate 101 is wound off from a bobbin set in the substrate-feeding container 202 and wound up around anther bobbin in the substrate winding container 203.

The semiconductor formation vacuum containers 211 to 216 each include a deposition chamber which forms a plasma generation region. High-frequency power is applied from high-frequency power supplies 251 to 256 to belt-shaped high-frequency introduction sections 241 to 246 in the deposition chambers to generate glow discharge, thereby discompose the source gas and deposit a semiconductor layer on the conductive substrate 101. The high-frequency introduction sections 241 to 246 face the conductive substrate 101 and is provided a height adjusting mechanism (not shown). The height adjusting mechanism allows the distance between the conductive substrate and the high-frequency introduction section to be changed and allows the volume of the discharge space to be changed at the same time. Furthermore, gas inlet tubes 231 to 236 for introducing a source gas or diluent gas are connected to the respective semiconductor formation vacuum containers 211 to 216. Furthermore, the high-frequency introduction sections in the semiconductor formation vacuum containers 213 and 214 are provided with a plurality of holes so that the source gas is introduced therethrough into the plasma space like a shower. Each deposition chamber is constructed such that the discharge space in which plasma is generated is limited in its upper and lower sections by the conductive substrate and the high-frequency introduction section and limited in its lateral direction by discharge plates placed so as to surround the high-frequency introduction section. Furthermore, in each semiconductor formation vacuum container, there is a film formation region adjusting plate (not shown) for adjusting the area of contact between the conductive substrate 101 and the discharge space in each deposition chamber.

First, a belt-shaped base (width: 50 cm, length: 1,500 m, thickness: 0.15 mm) made of stainless steel (SUS430BA) was degreased and cleaned sufficiently and mounted on a continuous sputtering apparatus (not shown) and an Ag thin film having a thickness of 100 nm was evaporated on the base by sputtering using the Ag electrode as the target. Furthermore, using the ZnO target, a ZnO thin film having a thickness of 300 nm was evaporated onto the Ag thin film by sputtering. Then, ZnO having a thickness of 2.7 µm was formed on the evaporated ZnO by using an electrodeposition method. As the formation conditions using the electrodeposition method, the concentration of zinc ions in an aqueous solution was 0.15 mol/l, PH = 5.0, the temperature of the aqueous solution was 85°C and the current flowing between the anode and cathode was 15 mA/cm². Then, a substrate formed in this way was placed in a drying container (not shown) connected to the vacuum pump and dried in a nitrogen atmosphere of 10 KPa at an atmosphere temperature of 250°C for 5 hours to complete the substrate 101.

Then, the bobbin around which the conductive substrate 101 was wound was set in the substrate feeding container 202, the conductive substrate 101 was passed through the gas gates on the inlet side, the semiconductor formation vacuum containers 211 to 216 and the gas gates on the outlet side up to the substrate winding container 203, and a tensile stress was applied to the belt-shaped conductive substrate 101 so as not to loosen. Then, the air in the substrate feeding container 202, semiconductor formation vacuum containers 211 to 216 and substrate winding container 203 was exhausted sufficiently by a vacuum exhaust system composed of a vacuum pump (not shown) to 5.0×10⁻⁴ Pa or less.

While operating the vacuum exhaust system, the source gas and diluent gas were supplied to the semiconductor formation vacuum containers 211 to 216 from the gas inlet tubes 231 to 236. At the same time, H₂ gas was supplied at 500 sccm to each gas gate as the gate gas from each gate gas supply tube. In this condition, the exhaust performance of the vacuum exhaust system was adjusted and the pressure inside the semiconductor formation vacuum containers 211 to 216 was adjusted to a predetermined pressure. The formation conditions are as shown in Table 1. The CS distance in the table means the distance between the conductive substrate and the high-frequency introduction section (electrode).

**Table 1**

| | | |
|---|---|---|
| Formation condition of 211 | Source gas | SiH₄: 20 cm³/min (normal) H₂: 300 cm³/min (normal) PH₃ (diluted to 2% with H₂): 50 cm³/min (normal) |
| | Substrate temperature | 200°C |
| | Pressure | 1,000 Pa |
| | High frequency | 13.56 MHz, 5 mW/cm³ |
| | CS distance | 10 mm |
| Formation condition of 212 | Source gas | SiH₄: 10 cm³/min (normal) H₂: 4,000 cm³/min (normal) |
| | Substrate temperature | 200°C |
| | Pressure | 1,000 Pa |
| | High frequency | 13.56 MHz, 150 mW/cm³ |
| | CS distance | 9 mm |
| Formation condition of 213, 214 | Source gas | SiH₄: 200 cm³/min (normal) SiF₄: 150 cm³/min (normal) H₂: 5,000 cm³/min (normal) |
| | Substrate temperature | 180°C |
| | Pressure | 1,000 Pa |
| | High frequency | 60 MHz, 1.5 W/cm³ |
| | CS distance | 7 mm |
| Formation condition of 215 | Source gas | SiH₄: 50 cm³/min (normal) H₂: 400 cm³/min (normal) |
| | Substrate temperature | 200°C |
| | Pressure | 1,000 Pa |
| | High frequency | 13.56 MHz, 10 mW/cm³ |
| | CS distance | 9 mm |
| Formation condition of 216 | Source gas | SiH₄: 10 cm³/min (normal) H₂: 800 cm³/min (normal) BF₃ (diluted to 2% with H₂): 100 cm³/min (normal) |
| | Substrate temperature | 150°C |
| | Pressure | 1,000 Pa |
| | High frequency | 13.56 MHz, 300 mW/cm³ |
| | CS distance | 10 mm |

When the pressure in the semiconductor formation vacuum containers 211 to 216 became stable, the movement of the conductive substrate 101 from the substrate feeding container 202 toward the substrate winding container 203 was started.

Then, a high frequency was introduced into the high-frequency introduction sections 241 to 246 in the semiconductor formation vacuum containers 211 to 216 from the high-frequency power supplies 251 to 256, glow discharge was generated in each deposition chamber in the semiconductor formation vacuum container 211 to 216, an amorphous n-type semiconductor layer 102-2E (film thickness: 30 nm, film formation rate: 0.1 nm/s), a microcrystalline intermediate layer 102-2D (film thickness: 20 nm, film formation rate: 0.1 nm/s), a microcrystalline i-type semiconductor layer 102-2C (film thickness: 2.0 µm, film formation rate: 3.0 nm/s), an amorphous intermediate layer 102-2B (film thickness: 20 nm, film formation rate: 0.2 nm/s), a microcrystalline p-type semiconductor layer 102-2A (film thickness: 10 nm, film formation rate: 0.1 nm/s) were formed on the conductive substrate 101 to thereby form the second pin-junction. Upon completion of the formation of the second pin-junction, the substrate winding container 203 was leaked, the conductive substrate 101 was taken out and exposed to the atmosphere. Then, the first pin-junction was formed. Then, the bobbin around which the conductive substrate 101 with the second pin-junction formed thereupon was wound was set in the substrate feeding container 202, the conductive substrate 101 was passed through the gas gates on the inlet side, the semiconductor formation vacuum containers 211 to 216 and the gas gates on the outlet side up to the substrate winding container 203, and a tensile stress was applied to the belt-shaped conductive substrate 101 so as not to loosen. Then, an amorphous n-type semiconductor layer 102-1E (film thickness: 20 nm, film formation rate: 0.1 nm/s), an amorphous intermediate layer 102-1D (film thickness: 20 nm, film formation rate: 0.2 nm/s), an amorphous i-type semiconductor layer 102-1C (film thickness: 0.40 µm, film formation rate: 0.9 nm/s), a microcrystalline intermediate layer 102-1B (film thickness: 20 nm, film formation rate: 0.1 nm/s), a microcrystalline p-type semiconductor layer 102-1A (film thickness: 10 nm, film formation rate: 0.1 nm/s) were formed on the second pin-junction to thereby form the first pin-junction. The formation conditions are as shown in Table 2. The CS distance in the table means the distance between the conductive substrate and the high-frequency introduction section.

**Table 2**

| | | |
|---|---|---|
| Formation condition of 211 | Source gas | SiH₄: 20 cm³/min (normal) H₂ : 500 cm³/min (normal) PH₃ (diluted to 2% with H₂): 100 cm³/min (normal) |
| | Substrate temperature | 230°C |
| | Pressure | 200 Pa |
| | High frequency | 13.56 MHz, 5 mW/cm ³ |
| | CS distance | 20 mm |
| Formation condition of 212 | Source gas | SiH₄: 50 cm³/min (normal) H₂: 3, 000 cm³/min (normal) |
| | Substrate temperature | 200°C |
| | Pressure | 200 Pa |
| | High frequency | 13.56 MHz, 15 mW/cm³ |
| | CS distance | 20 mm |
| Formation condition of 213, 214 | Source gas | SiH₄: 300 cm³/min (normal) H₂: 4,000 cm³/min (normal) |
| | Substrate temperature | 220°C |
| | Pressure | 200 Pa |
| | High frequency | 60 MHz, 50 mW/cm³ |
| | CS distance | 10 mm |
| Formation condition of 215 | Source gas | SiH₄: 10 cm³/min (normal) H₂: 1,000 cm³/min (normal) |
| | Substrate temperature | 200°C |
| | Pressure | 200 Pa |
| | High frequency | 13.56 MHz, 100 mW/cm³ |
| | CS distance | 20 mm |
| Formation condition of 216 | Source gas | SiH₄: 20 cm³/min (normal) H₂: 2,000 cm³/min (normal) BF₃ (diluted to 2% with H₂): 100 cm³/min (normal) |
| | Substrate temperature | 150°C |
| | Pressure | 200 Pa |
| | High frequency | 13.56 MHz, 300 mW/cm³ |
| | CS distance | 20 mm |

Then, using a continuous modularization apparatus (not shown), the belt-shaped photovoltaic element formed in this way was babricated into a solar cell module (Example 1).

### <Comparative Example 1>

Then, a solar cell module was fabricated using the same procedure as that in Example 1 except that an amorphous intermediate layer under the formation conditions shown in Table 3 (Comparative Example 1) was used instead of the microcrystalline intermediate layer 102-2D in Example 1. The CS distance in the table means the distance between the conductive substrate and high-frequency introduction section (electrode).

**Table 3**

| | | |
|---|---|---|
| Formation condition of 212 | Source gas | SiH₄: 50 cm³/min (normal) H₂: 1,000 cm³/min (normal) |
| | Substrate temperature | 200°C |
| | Pressure | 1,000 Pa |
| | High frequency | 13.56 MHz, 15 mW/cm³ |
| | CS distance | 9 mm |

### <Comparative Example 2>

Then, a solar cell module was fabricated using the same procedure as that in Example 1 except that the amorphous intermediate layer 102-2B in Example 1 was not formed (Comparative Example 2).

### <Comparative Example 3>

Then, a solar cell module was fabricated using the same procedure as that in Example 1 except that a microcrystalline intermediate layer under the formation conditions shown in Table 4 (Comparative Example 3) was used instead of the amorphous intermediate layer 102-1D in Example 1. The CS distance in the table means the distance between the conductive substrate and high-frequency introduction section (electrode).

**Table 4**

| | | |
|---|---|---|
| Formation condition of 212 | Source gas | SiH₄: 30 cm³/min (normal) H₂: 4,000 cm³/min (normal) |
| | Substrate temperature | 200°C |
| | Pressure | 200 Pa |
| | High frequency | 13.56 MHz, 100 mW/cm³ |
| | CS distance | 20 mm |

### <Comparative Example 4>

Then, a solar cell module was fabricated using the same procedure as that in Example 1 except that an amorphous intermediate layer under the formation conditions shown in Table 5 (Comparative Example 4) was used instead of the microcrystal intermediate layer 102-1B in Example 1. The CS distance in the table means the distance between the conductive substrate and high-frequency introduction section (electrode).

**Table 5**

| | | |
|---|---|---|
| Formation condition of 215 | Source gas | SiH₄: 30 cm³/min (normal) H₂: 1,000 cm³/min (normal) |
| | Substrate temperature | 200°C |
| | Pressure | 200 Pa |
| | High frequency | 13.56 MHz, 10 mW/cm³ |
| | CS distance | 20 mm |

The photoelectrical conversion efficiency of the solar cell module fabricated as shown above was measured using a solar simulator (AM 1.5, 100 mW/cm²). The result is shown in Table 6.

**Table 6**

| | Photoelectrical conversion efficiency |
|---|---|
| Example 1 | 1 |
| Comparative Example 1 | 0.85 |
| Comparative Example 2 | 0.90 |
| Comparative Example 3 | 0.93 |
| Comparative Example 4 | 0.95 |

Values when the photoelectrical conversion efficiency of the solar cell module in Example 1 is standardized at 1 are shown in Table 6.

It is evident from Table 6 that the solar cell modules in the comparative examples have relatively poorer photoelectrical conversion efficiency than that of the solar cell in Example 1. The solar cell module in Comparative Example 1 had higher crystal grain boundary density of the initially formed film of the microcrystalline i-type semiconductor layer 102-2C and was especially inferior in short-circuit current density and fill factor compared to Example 1. The solar cell module in Comparative Example 2 was especially inferior in points of short-circuit current and open-circuit voltage. This seems to be attributable to the fact that a mismatching region was formed in the vicinity of the interface between the microcrystalline p-type semiconductor layer 102-2A made of small quasi-spherical crystal grains and the microcrystalline i-type semiconductor layer 102-2C preferentially extending in the film thickness direction. In contrast, in the case of Example 1, it seems that the insertion of the intermediate layer 102-2B prevented carriers generated in the i-type semiconductor layer from diffusing into the p-type layer side. The solar cell module in Comparative Example 3 was especially inferior to Example 1 in points of fill factor and open-circuit voltage. This seems to be attributable to the fact that because the intermediate layer 102-1D was made of a microcrystal phase, greater high-frequency power was applied under a lower formation pressure than the formation pressure of the intermediate layer 102-2D of the second pin-junction, which possibly caused plasma damage to the amorphous n-type semiconductor layer 102-1E. The solar cell module in Comparative Example 4 was especially inferior in the open-circuit voltage value. This seems to be attributable to the fact that because the microcrystalline p-type semiconductor layer 102-2A was formed on the amorphous intermediate layer, the same film thickness as that of Example 1 did not allow the microcrystal structure having a desired conductive characteristic to grow. As explained above, it is evident that the solar cell using the photovoltaic element of the present invention has excellent characteristics.

### <Example 2>

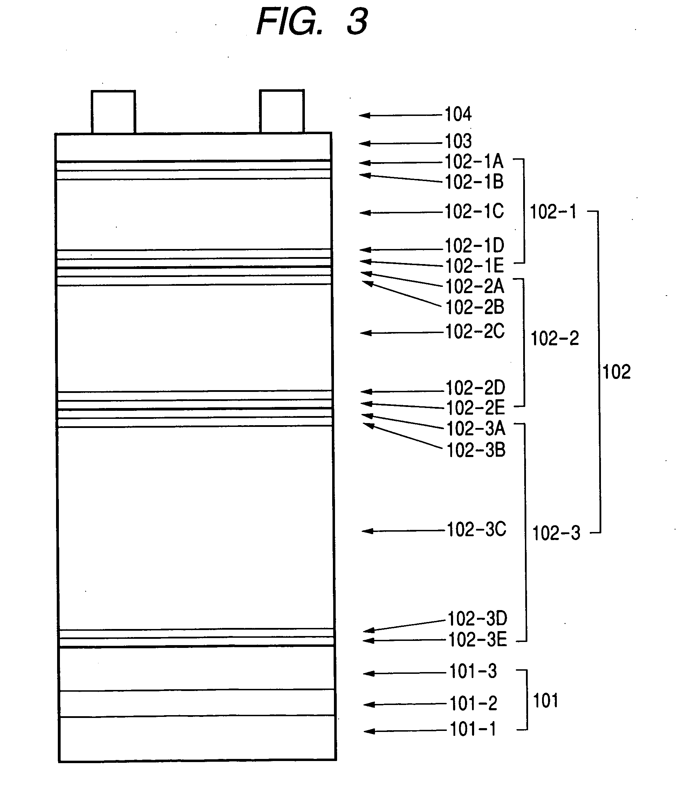

The photovoltaic element shown in FIG. 3 was formed using the same procedure as that in Example 1. FIG. 3 is a schematic cross-sectional view showing an example of the photovoltaic element of the present invention. The semiconductor layer of this photovoltaic element has a structure with one pin-junction added to the semiconductor layer in Example 1, that is, with the first pin-junction 102-1, second pin-junction 102-2 and third pin-junction 102-3 arranged in series. The first pin-junction consists of a microcrystalline p-type semiconductor layer 102-1A, a microcrystalline intermediate layer 102-1B, an amorphous i-type semiconductor layer 102-1C, an amorphous intermediate layer 102-1D and an amorphous n-type semiconductor layer 102-1E, the second pin-junction consists of a microcrystalline p-type semiconductor layer 102-2A, an amorphous intermediate layer 102-2B, a microcrystalline i-type semiconductor layer 102-2C, a microcrystalline intermediate layer 102-2D and an amorphous n-type semiconductor layer 102-2E and the third pin-junction consists of a microcrystalline p-type semiconductor layer 102-3A, an amorphous intermediate layer 102-3B, a microcrystalline i-type semiconductor layer 102-3C, a microcrystalline intermediate layer 102-3D and an amorphous n-type semiconductor layer 102-3E. The first pin-junction in the present example was formed under the same formation condition as that of the first pin-junction in Example 1 and the second pin-junction and third pin-junction in the present example were formed under the same formation condition as that of the second pin-junction in Example 1. Furthermore, in order to balance the currents among the respective pin-junctions, the film thicknesses of the i-type semiconductor layers of the respective pin-junctions were adjusted; the amorphous i-type semiconductor layer 102-1C to 0.25 µm, the microcrystalline i-type semiconductor layer 102-2C to 1.5 µm, the microcrystalline i-type semiconductor layer 102-3C to 2.8 µm. Then, using a continuous modularization apparatus (not shown), the formed belt-shaped photovoltaic element was fabricated into a solar cell module (Example 2) . When the photoelectrical conversion efficiency of the solar cell module fabricated in this way was measured using a solar simulator (AM 1.5, 100 mW/cm²), a photoelectrical conversion efficiency 1.15 times that of the solar cell module in Example 1 was obtained. As explained above, it is evident that the solar cell using the photovoltaic element of the present invention has excellent characteristics.

The present invention provides a photovoltaic element including a structure with a first pin-junction having an i-type semiconductor layer made of amorphous silicon and a second pin-junction having an i-type semiconductor layer contains crystalline silicon which are arranged in series on a substrate, wherein the first pin-junction has a first intermediate layer at a p/i interface and a second intermediate layer at an n/i interface, and the second pin-junction has a third intermediate layer at a p/i interface and a fourth intermediate layer at an n/i interface, and wherein the second intermediate layer and the third intermediate layer are made of amorphous silicon and the first intermediate layer and the fourth intermediate layer contain crystalline silicon, or wherein the second intermediate layer and the third intermediate layer contain crystalline silicon and the first intermediate layer and the fourth intermediate layer are made of amorphous silicon.

## Claims

1. A photovoltaic element formed on a substrate, comprising a first semiconductor layer and a second semiconductor layer containing crystalline silicon of at least different conductivity types and/or shapes from each other,
wherein an amorphous intermediate layer is arranged between the first semiconductor layer and the second semiconductor layer.

2. The photovoltaic element according to claim 1, wherein either one of the first semiconductor layer and the second semiconductor layer is a p-type or n-type semiconductor layer and the other is a substantially intrinsic semiconductor layer.

3. A photovoltaic element comprising a structure with a first pin-junction having an i-type semiconductor layer made of amorphous silicon and a second pin-junction having an i-type semiconductor layer containing crystalline silicon which are arranged in series on a substrate,
wherein the first pin-junction has a first intermediate layer at a p/i interface and a second intermediate layer at an n/i interface, and the second pin-junction has a third intermediate layer at a p/i interface and a fourth intermediate layer at an n/i interface,
wherein the second intermediate layer and the third intermediate layer are made of amorphous silicon and the first intermediate layer and the fourth intermediate layer contain crystalline silicon, or the second intermediate layer and the third intermediate layer contain crystalline silicon and the first intermediate layer and the fourth intermediate layer are made of amorphous silicon.

4. A photovoltaic element comprising a structure with a first pin-junction having an i-type semiconductor layer made of amorphous silicon and a second pin-junction having an i-type semiconductor layer made of crystalline silicon which are arranged in series on a substrate,
wherein the first pin-junction has a first intermediate layer containing crystalline silicon at an interface on an incident light side of the i-type semiconductor layer and a second intermediate layer containing amorphous silicon at an interface on a back side of the i-type semiconductor layer, and the second pin-junction has a third intermediate layer containing amorphous silicon at an interface on an incident light side of the i-type semiconductor layer and a fourth intermediate layer containing crystalline silicon at an interface on a back side of the i-type semiconductor layer.

5. A photovoltaic element comprising a structure with a first pin-junction having an i-type semiconductor layer made of amorphous silicon and a second pin-junction having an i-type semiconductor layer made of crystalline silicon which are arranged in series on a substrate,
wherein an interface on a first side of the i-type semiconductor layer of the first pin-junction is in contact with a layer containing microcrystalline silicon,
an interface on a second side of the i-type semiconductor layer of the first pin-junction is in contact with a layer made of amorphous silicon,
an interface on a first side of the i-type semiconductor layer of the second pin-junction is in contact with a layer containing amorphous silicon, and
an interface on a second side of the i-type semiconductor layer of the second pin-junction is in contact with a layer containing microcrystalline silicon.

6. The photovoltaic element according to claim 1, wherein a formation rate of the intermediate layer is smaller than a formation rate of the i-type semiconductor layer, and a film thickness of the intermediate layer is equal to or smaller than 1/5 of a film thickness of the i-type semiconductor layer.

7. The photovoltaic element according to claim 1, wherein the intermediate layer is made of a substantially intrinsic semiconductor layer.

8. The photovoltaic element according to claim 1, wherein the intermediate layer is made of a semiconductor layer of the same conductivity type as a conductivity type of an adjacent n- or p-type semiconductor layer.

9. The photovoltaic element according to claim 3, wherein the p-type semiconductor layer of the first pin-junction is made of crystalline silicon, and the n-type semiconductor layer of the first pin-junction is made of amorphous silicon.

10. The photovoltaic element according to claim 3, wherein the p-type semiconductor layer of the second pin-junction is made of crystalline silicon, and the n-type semiconductor layer of the second pin-junction is made of amorphous silicon.

11. The photovoltaic element according to claim 3, wherein the i-type semiconductor layer of the second pin-junction is made of crystalline silicon in a shape extending in a film deposition direction, and the p-type semiconductor layer of the second pin-junction is made of crystalline silicon in a quasi-spherical shape.

12. The photovoltaic element according to claim 3, wherein a plurality of the first pin-junctions and/or the second pin-junctions are arranged in series.

13. A method of forming a photovoltaic element, which comprising:
applying a high frequency to a high-frequency introduction section to carry out high-frequency plasma CVD, the high-frequency introduction section facing a substrate, and the substrate and high frequency introduction section being arranged in a reaction container that can be decompressed; and
forming a photovoltaic element comprising a first pin-junction having an i-type semiconductor layer made of amorphous silicon, a second pin-junction having an i-type semiconductor layer made of crystalline silicon which are arranged in series on the substrate, and an intermediate layer at a p/i interface or n/i interface of the pin-junctions,
wherein a high frequency for forming the i-type semiconductor layer is greater than a frequency for forming the intermediate layer.

14. The method of forming a photovoltaic element according to claim 13, wherein a high frequency for forming the i-type semiconductor layer is greater than a frequency for forming the n-type semiconductor layer and p-type semiconductor layer.

15. The method of forming a photovoltaic element according to claim 13, wherein a formation pressure of the i-type semiconductor layer included in the second pin-junction is greater than a formation pressure of the i-type semiconductor layer included in the first pin-junction.

16. The method of forming a photovoltaic element according to claim 15, wherein a formation pressure of the i-type semiconductor layer included in the second pin-junction is equal to or greater than three times a formation pressure of the i-type semiconductor layer included in the first pin-junction.

17. The method of forming a photovoltaic element according to claim 13, wherein when the first pin-junction is formed, a distance between the substrate and the high-frequency introduction section when the i-type semiconductor layer is formed is smaller than a distance between the substrate and the high-frequency introduction section when the n-type semiconductor layer, intermediate layer and p-type semiconductor layer are formed.

18. The method of forming a photovoltaic element according to claim 13, wherein when the second pin-junction is formed, a distance between the substrate and the high-frequency introduction section when the i-type semiconductor layer is formed is smaller than a distance between the substrate and the high-frequency introduction section when the n-type semiconductor layer, intermediate layer and p-type semiconductor layer are formed.

19. The method of forming a photovoltaic element according to claim 14, wherein a distance between the substrate and the high-frequency introduction section when the i-type semiconductor layer of the first pin-junction is formed is greater than a distance between the substrate and the high-frequency introduction section when the i-type semiconductor layer of the second pin-junction is formed.
